## Europäisches Patentamt

## European Patent Office

## Office européen des brevets

(19)

(11) Veröffentlichungsnummer: **0 107 032**
**B1**

(12) **EUROPÄISCHE PATENTSCHRIFT**

(45) Veröffentlichungstag der Patentschrift:
**10.12.86**

(51) Int. Cl.⁴: **G 01 R 31/28**

(21) Anmeldenummer: **83109269.7**

(22) Anmeldetag: **19.09.83**

(54) **Verfahren zur Unterdrückung einer Störung bei der Messung von Signalverläufen mit einer Korpuskularsonde und Vorrichtung zur Durchführung eines solchen Verfahrens.**

(30) Priorität: **24.09.82 DE 3235484**

(43) Veröffentlichungstag der Anmeldung:
**02.05.84 Patentblatt 84/18**

(45) Bekanntmachung des Hinweises auf die Patenterteilung:
**10.12.86 Patentblatt 86/50**

(84) Benannte Vertragsstaaten:
**DE FR GB NL**

(56) Entgegenhaltungen:
**US - A - 4 220 854**
**US - A - 4 277 679**

(73) Patentinhaber: **Siemens Aktiengesellschaft Berlin und München, Wittelsbacherplatz 2, D-8000 München 2 (DE)**

(72) Erfinder: **Feuerbaum, Hans-Peter, Dr. Dipl.-Phys., Arno-Assmann-Strasse 14, D-8000 München 83 (DE)**
Erfinder: **Schmitt, Reinhold, Dipl.-Ing., Tucholskystrasse 18, D-8000 München 83 (DE)**

## Beschreibung

Die Erfindung betrifft ein Verfahren zur Unterdrückung einer Störung bei der Messung von Signalverläufen mit einer Korpuskularsonde nach dem Oberbegriff des Anspruchs 1 und eine Vorrichtung zur Durchführung eines solchen Verfahrens.

Bei der Messung von Signalverläufen mit einer Elektronensonde können Störungen durch Kontamination des Messobjekts und durch Strahlstromschwankungen bei der Elektronensonde auftreten.

Diese Störungen konnten bisher durch das aus einer Veröffentlichung von H.P. Feuerbaum, Scanning Electron Microscopy/1979/I, 285–296, bekannte Verfahren der Phasenmodulation nahezu beseitigt werden, wenn diese Störungen nur wenige Prozent des Messignals betragen. Die Leistungsfähigkeit dieses bekannten Verfahrens der Phasenmodulation reicht jedoch bei den heutigen Anwendungen nicht mehr aus. Ein solches bekanntes Verfahren der Phasenmodulation beseitigt nämlich lediglich die infolge von Störungen auftretenden Drifterscheinungen bei einem Messignal. Im allgemeinen driftet jedoch ein solches Messignal nicht nur, sondern es wird auch ungenauer.

Der vorliegenden Erfindung liegt die Aufgabe zugrunde, ein Verfahren der eingangs genannten Art anzugeben, mit dem sowohl die bei einem Messignal auftretenden Drifterscheinungen beseitigt werden können als auch die Genauigkeit der Messung von Signalverläufen wesentlich erhöht werden kann.

Diese Aufgabe wird erfindungsgemäss durch ein Verfahren nach dem Anspruch 1 gelöst. Ausgestaltungen und Vorteile der Erfindung sind in den Unteransprüchen, der Beschreibung und der Zeichnung dargestellt.

Ausführungsbeispiele der Erfindung werden im folgenden anhand der Zeichnung näher erläutert.

Fig. 1 erläutert das Prinzip der Phasenmodulation.

Fig. 2 zeigt eine Vorrichtung zur Durchführung eines erfindungsgemässen Verfahrens.

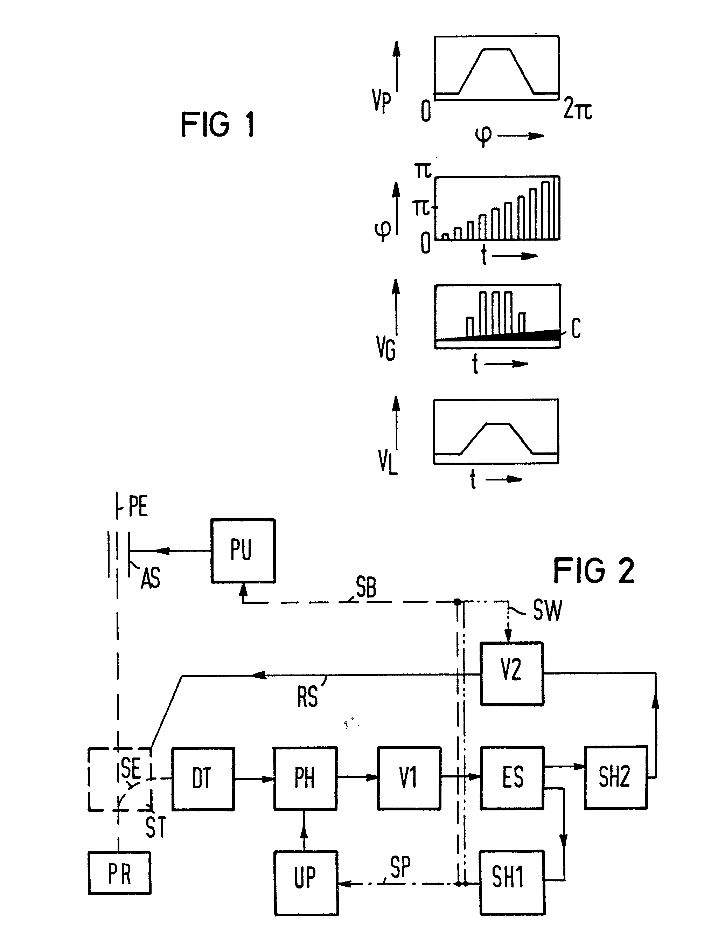

Fig. 1 erläutert das Prinzip der Phasenmodulation. Ein erfindungsgemässes Verfahren zur Störunterdrückung bei der Messung von Signalverläufen mit der Elektronensonde PE beruht auf dem Prinzip der Phasenmodulation. Deshalb wird dieses Verfahren der Phasenmodulation im Zusammenhang mit der Beschreibung einer Vorrichtung zur Durchführung eines erfindungsgemässen Verfahrens nach Fig. 2 noch einmal beschrieben. Eine Vorrichtung zur Durchführung eines erfindungsgemässen Verfahrens nach Fig. 2 besteht im wesentlichen aus einer Vorrichtung, wie sie in der oben angegebenen Veröffentlichung von H.P. Feuerbaum oder auch in der US-PS 4 277 679 oder US-PS 4 220 854 beschrieben worden ist.

Zur Bestimmung des Potentials an einem Messpunkt in einer Probe PR, beispielsweise in einer integrierten Schaltung, werden die von einem Primär-Elektronenstrahl PE ausgelösten Sekundärelektronen SE in einem Spektrometer ST hinsichtlich ihrer Energie analysiert. Niederenergetische Sekundärelektronen SE können dabei ein innerhalb dieses Spektrometers ST erzeugtes Gegenfeld nicht überwinden. Höherenergetische Sekundärelektronen SE werden von einem Detektor DT nachgewiesen. Die Energieverteilung der Sekundärelektronen SE hängt von dem Potential des Messpunkts auf der Probe PR ab. Bei einer Änderung dieses Potentials an einem Messpunkt auf der Probe PR wird die Energieverteilung der Sekundärelektronen SE im wesentlichen auf einer Energieskala verschoben. Diese Verschiebung der Energieverteilung der Sekundärelektronen SE wird mit dem oben erwähnten Gegenfeld des Spektrometers ST nachgewiesen. Dabei wird eine Rückkopplungsschaltung RS verwendet, die das Signal der Sekundärelektronen, die das Gegenfeld des Spektrometers ST überwinden können, konstant hält. Potentialänderungen am Messpunkt auf der Probe PR haben daher eine gleiche Spannungsänderung an der in der Fig. 2 nicht eingezeichneten Gegenfeld-Elektrode des Spektrometers ST zur Folge. Die Spannung an der Gegenfeld-Elektrode des Spektrometers ST liefert somit das Messignal. Die Spannung an der Gegenfeld-Elektrode des Spektrometers ST wird von der Rückkopplungsschaltung RS gesteuert. Störungen beeinflussen die Energieverteilung der am Messpunkt auf der Probe PR ausgelösten Sekundärelektronen SE. Über die Rückkopplungsschaltung RS wird infolgedessen die Spannung an der Gegenfeld-Elektrode des Spektrometers ST so gesteuert, dass das vom Detektor DT wahrgenommene Sekundärelektronen-Messignal konstant bleibt. Damit ist jedoch die Messung des Potentials an dem Messpunkt auf der Probe PR verfälscht. Am Beispiel der Kontamination soll dieser Zusammenhang verdeutlicht werden.

Kontaminiert ein Messpunkt, so verringert sich das Sekundärelektronen-Messignal. Als Folge davon verschiebt sich die Spannung an der Gegenfeld-Elektrode des Spektrometers ST in die positive Richtung. Mit zunehmender Kontamination können daher immer mehr niederenergetische Sekundärelektronen SE das Gegenfeld des Spektrometers ST überwinden und zum Sekundärelektronen-Messignal beitragen. Diese niederenergetischen Sekundärelektronen SE verschlechtern jedoch prinzipiell die Messgenauigkeit. Denn wenn ein Messpunkt kontaminiert, so driftet die an der Gegenfeld-Elektrode des Spektrometers ST angelegte Spannung, aus der das zu messende Potential am Messpunkt auf der Probe PR abgeleitet wird, nicht nur in die positive Richtung, sondern diese Spannung an der Gegenfeld-Elektrode und damit auch die gemessene Spannung wird auch ungenauer. Durch Phasenmodulation kann jedoch nur die Drift der gemessenen Spannung ausgeschaltet werden. Bei diesem Verfahren der Phasenmodulation wird während der kontinuierlichen Abtastung eines Signalverlaufs das ebenfalls driftende Signal einer konstanten Referenzphase mitgemessen. Die Differenz von Messignal und Referenzsignal ist frei von Drift, gibt aber Potentialänderungen nur ungenau wieder. Durch Kontamination verursachte Störungen beeinträchtigen die Messgenauigkeit bereits so, dass reproduzierbare Messungen im mV-Bereich kaum möglich sind.

Bei der Methode der Phasenmodulation nach Fig. 1 wird die Spannung am Messpunkt auf der Probe PR zwischen dem zu vermessenden Potential und einer Referenzspannung hin- und hergeschaltet. Die Referenzspannung mag dabei beispielsweise 0 Volt betragen. In Fig. 1 ist beispielsweise eine Periode einer zu messenden Spannung $V_P$ dargestellt. Beim Abtasten der Wellenform dieser Spannung $V_P$ wird die Phase $\varphi$ der Primär-Elektronensonde PE nicht wie üblich kontinuierlich verändert, sondern sprungweise. Dabei trifft die Primär-Elektronensonde PE auf die Oberfläche der Probe PR alternierend einmal mit einer sprungweise zugenommenen Phase $\varphi$ und dann wieder mit einer Referenzphase, die in Fig. 1 mit $\varphi = 0$ gezeigt ist, auf. Das System zur Verarbeitung der Sekundärelektronen Messignale misst die Spannung $V_G$ während der sprungweise zugenommenen Phase und während der Referenzphase, und liefert sodann die Differenz dieser Spannungen $V_G$ als das Messergebnis. Die Spannung $V_G$ enthält nämlich aufgrund der Phasenmodulation der Primär-Elektronensonde PE eine Wechselspannungskomponente. Diese Wechselspannungskomponente kann mit Hilfe eines lockin-Verstärkers detektiert und über mehrere Phasen der Primär-Elektronensonde PE hinweg integriert werden. Als Ergebnis dieser Prozedur erhält man die Spannung $V_L$, welche unbeeinflusst von Drift-Störungen ist.

Die Methode der Phasenmodulation kann auch dann angewendet werden, wenn an dem Messpunkt auf der Probe PR lediglich eine Gleichspannung zu messen ist. Dann kann beispielsweise die Spannung an dem Messpunkt während der Messung alternierend zwischen der zu vermessenden Gleichspannung und 0 Volt hin- und hergeschaltet werden. Dadurch kann ebenso wie bei der Methode nach Fig. 1 die infolge von Kontamination auftretende zusätzliche Drift-Spannung C ermittelt und von der Messkurve abgezogen werden.

Ein erfindungsgemässes Verfahren lehnt sich an das Verfahren der Phasenmodulation an. Das in der Referenzphase gemessene Sekundärelektronen-Signal wird jedoch bei einem erfindungsgemässen Verfahren dazu benutzt, dass die Rückkopplungsschaltung RS auf einen bestimmten Arbeitspunkt abgeglichen wird. Wird die Rückkopplungsschaltung RS dabei auf einen vorgegebenen Arbeitspunkt abgeglichen, so wird trotz der Störungen, welche das Sekundärelektronen-Messignal beeinflussen, das Gegenfeld im Spektrometer ST ständig konstant gehalten. Die in der Referenzphase am Messpunkt auf der Probe PR ausgelösten Sekundärelektronen, welche das Gegenfeld des Spektrometers ST überwinden können, werden vom Detektor DT nachgewiesen. Die vom Detektor DT nachgewiesenen Sekundärelektronen SE bewirken am Ausgang des an den Detektor DT angeschlossenen Fotomultipliers PH ein Sekundärelektronen-Messignal, welches in einem Verstärker V1 verstärkt wird und sodann zu einem elektronischen Schalter ES gelangt. Das in der Referenzphase gemessene Sekundärelektronen-Messignal wird sodann in einer Sample-and Hold-Schaltung SH1 erfasst und kann in einem in der Zeichnung nicht dargestellten Komparator mit einem Soll-Wert für dieses Sekundärelektronen-Messignal, welches während der Referenzphase ermittelt wird, verglichen werden. Abweichungen von diesem Soll-Wert werden verstärkt und steuern bei einem erfindungsgemässen Ausführungsbeispiel die Verstärkung eines Fotomultipliers PH oder den Verstärkungsfaktor eines nachgeschalteten Verstärkers V2 oder steuern die Pulsbreite der Primärelektronen PE über einen Pulsgenerator PU und über ein Strahlaustastsystem AS so, dass das in der Referenzphase gemessene Sekundärelektronen-Messignal dem Soll-Wert für dieses während der Referenzphase gemessene Sekundärelektronen-Messignal entspricht. Die Steuerung der Verstärkung eines Fotomultipliers PH erfolgt dabei so, dass der Ausgang der Sample- and Hold-Schaltung SH1 die Spannungsversorgung UP des Fotomultipliers PH so ansteuert, dass die Spannung des Fotomultipliers PH einen solchen Wert annimmt, dass das während der Referenzphase gemessene Sekundärelektronen-Messignal mit dem Soll-Wert für dieses Messignal übereinstimmt.

Bei einem alternativen Ausführungsbeispiel der Erfindung ist an einen zweiten Ausgang des elektronischen Schalters ES eine zweite Sample- and Hold-Schaltung SH2 angeschlossen, deren Ausgang wiederum an den Verstärker V2 angeschlossen ist strich-punktierte Verbindung in Fig. 2, dessen Ausgang wiederum direkt an die Gegenfeld-Elektrode des Spektrometers ST angeschlossen ist, wodurch die Rückkopplungsschleife RS geschlossen ist. Wenn am Messpunkt auf der Probe PR die zu messende Spannung anliegt, wird das Sekundärelektronen-Messignal vom elektronischen Schalter ES an die Sample- and Hold-Schaltung SH2 weitergegeben.

In einem alternativen Ausführungsbeispiel der Erfindung kann der Verstärkungsfaktor, beispielsweise des Vestärkers V2, über den Ausgang der Sample- and Hold-Schaltung SH1 so gesteuert werden, dass das während einer Referenzphase gemessene Sekundärelektronen-Messignal mit dem Soll-Wert dieses Messignals übereinstimmt.

Weitere Ausführungsbeispiele der Erfindung beruhen darauf, dass bei konstanter Verstärkung innerhalb der Rückkopplungsschleife RS der Soll-Wert für das Sekundärelektronen-Messignal geregelt wird. Diese Regelung erfolgt so, dass das während einer Referenzphase gemessene Sekundärelektronen-Messignal als neuer Soll-Wert für dasjenige Sekundärelektronen-Messignal herangezogen wird, welche zur Ermittlung einer zu messenden Spannung am Messpunkt auf der Probe PR herangezogen wird.

Bei einem erfindungsgemässen Verfahren hält die Rückkopplungsschaltung RS die Barriere im Spektrometer ST unabhängig von Störungen konstant. Damit ist auch das in den anderen Phasen, die keine Referenzphasen sind, gemessene Sekundärelektronen-Messignal frei von Störungen. Die bei der Phasenmodulation übliche Subtraktion des Messignals vom Referenzsignal kann bei einem erfindungsgemässen Verfahren prinzipiell entfallen. Da eine solche übliche Subtraktion aber das Messignal vom Untergrund trennt, sollte sie trotzdem durchgeführt werden.

Die Bandbreite eines erfindungsgemässen Verfahrens zur Unterdrückung von Störungen lässt sich auf ca. 10 kHz abschätzen. Damit werden auch Störungen durch Strahlstromschwankungen, wie sie bei Feldemissions-Kathoden auftreten, unterdrückt, ohne dass ein Eingriff in die Elektronenoptik erforderlich ist.

Prinzipiell ist ein erfindungsgemässes Verfahren, das die Verstärkung oder den Soll-Wert steuert, demjenigen Verfahren überlegen, welches die Pulsbreite der Primärelektronen PE steuert, denn bei Variationen der Pulsbreite der Primärelektronen PE ändert sich auch die Zeitauflösung der Anordnung. Dies kann bei der Messung von sehr schnellen Anstiegsflanken zu stufenartigen Signalverläufen führen, d.h. ein erfindungsgemässes Verfahren, welches die Pulsbreite der Primärelektronen PE ändert, kann bei schnellen Signaländerungen im Vergleich mit anderen erfindungsgemässen Verfahren nur kleine Störungen korrigieren.

Ein erfindungsgemässes Verfahren, welches die Fotomultiplier-Verstärkung steuert, benötigt die strichpunktiert gezeichnete Leitung SP. Ein Verfahren, welches den Verstärkungsfaktor eines Verstärkers V2 steuert, benötigt eine doppelt strichpunktiert gezeichnete Steuerleitung SW. Ein erfindungsgemässes Verfahren, welches die Pulsbreite der Primärelektronen PE steuert, benötigt eine Steuerleitung SB. Ein erfindungsgemässes Verfahren, welches den Soll-Wert regelt, kann beispielsweise ebenfalls die Steuerleitung SP benutzen und die Spannung des Fotomultipliers steuern.

Ein erfindungsgemässes Verfahren ermöglicht folgende Vorteile:

Die Erfindung ermöglicht eine automatische Arbeitspunkt-Einstellung, bei der die bisherige individuelle Justierung des Arbeitspunkts entfällt.

Die Erfindung ermöglicht eine Unterdrückung von Strahlstromschwankungen. Insbesondere bei der Steuerung der Fotomultiplier-Spannung können Störungen unterdrückt werden, die das Signal um ein Vielfaches übertreffen. Damit sollte der Einsatz von Feldemissions-Kathoden in der Elektronenstrahl-Messtechnik möglich sein.

Die Erfindung ermöglicht eine Unterdrückung von Kontaminationseinflüssen. Die Verschiebung des Arbeitspunktes durch Kontamination wird während einer Messung ständig kompensiert. Die früher durch Drift aufgetretenen Messfehler werden um mehrere Grössenordnungen reduziert.

Die Funktion der in Fig. 2 dargestellten Schaltungsteile elektronischer Schalter ES, Sample- and Hold-Schaltung SH1 und Sample- and Hold-Schaltung SH2 kann prinzipiell auch von einer einzigen Sample- and Hold-Schaltung und einem an den Ausgang dieser Sample- and Hold-Schaltung angeschlossenen elektronischen Schalter erfüllt werden, von dem ein Ausgang zum Verstärker V2 und der andere Ausgang zum Knotenpunkt der verschiedenen Steuerleitungen SP, SB, SW führt.

**Patentansprüche**

1. Verfahren zur Unterdrückung einer Störung bei der Messung von Signalverläufen mit einer Korpuskularsonde (PE), bei dem die Korpuskularsonde (PE) auf einer Probe (PR) positioniert und die vom Potential der Probe (PR) abhängige Verschiebung der Energieverteilung der Sekundärelektronen (SE) mit einer Spektrometer-Detektoranordnung (ST, DT) bestimmt wird, bei dem das in der Spektrometer-Detektoranordnung (ST, DT) gemessene Sekundärelektronen-Signal über eine Rückkopplungsschaltung (RS) konstant gehalten wird, und bei dem zumindestens einem Zeitpunkt eine bekannte Referenzspannung auf der Probe (PR) gemessen wird, dadurch gekennzeichnet, dass das aus der Messung der Referenzspannung resultierende Sekundärelektronen-Signal zum Abgleich der Rückkopplungsschaltung (RS) auf einen vorgegebenen Arbeitspunkt benutzt wird, um die während der Messung der Signalverläufe durch Störungen verursachten Verschiebungen des Arbeitspunktes zu kompensieren.

2. Verfahren nach Anspruch 1, dadurch gekennzeichnet, dass bei Abweichungen eines Sekundärelektronen-Messignals, welches aus einer Messung einer Referenzspannung resultiert, von einem entsprechenden Soll-Wert die Spannung eines Fotomultipliers (PH) geändert wird.

3. Verfahren nach einem der Ansprüche 1 oder 2, dadurch gekennzeichnet, dass bei Abweichungen des Sekundärelektronen-Signals, welches aus einer Messung einer Referenzspannung resultiert, von einem entsprechenden Soll-Wert der Verstärkungsfaktor eines nachgeschalteten Verstärkers (V2) geändert wird.

4. Verfahren nach einem der Ansprüche 1 bis 3, dadurch gekennzeichnet, dass bei Abweichungen des Sekundärelektronen-Signals, welches aus einer Messung einer Referenzspannung resultiert, von einem entsprechenden Soll-Wert die Pulsbreite der Primärkorpuskeln (PE) so geändert wird, dass diese Abweichung verschwindet.

5. Verfahren nach Anspruch 1, dadurch gekennzeichnet, dass das Sekundärelektronen-Signal, welches aus einer Messung einer Referenzspannung resultiert, dazu benutzt wird, den Soll-Wert dieses Sekundärelektronen-Signals zu regeln.

6. Verfahren nach einem der Ansprüche 1 bis 5, dadurch gekennzeichnet, dass von dem Messignal einer zu ermittelnden Spannung das Messignal einer Referenzspannung zur Unterdrückung eines Signaluntergrunds subtrahiert wird.

7. Vorrichtung zur Durchführung eines Verfahrens nach einem der Ansprüche 1 bis 6 mit einem Korpuskularstrahlerzeuger, einer Anordnung (AS, PU) zum Aus- und Eintasten des Korpuskularstrahles (PE), einer Spektrometer-Detektoranordnung (ST, DT) zum Nachweis der auf einer Probe (PR) ausgelösten Sekundärelektronen (SE) und einer Schaltungsanordnung (RS) mit der das in der Spektrometer-Detektoranordnung (ST, DT) gemessene Sekundärelektronen-Signal konstant gehalten wird, gekennzeichnet durch einen elektronischen Schalter (ES) zum Umschalten des Sekundärelektronen-Signals zwischen einer Sample- and Hold-Schaltung (SH1) für das Messignal einer Referenzspannung und einer Sample- and Hold-Schaltung (SH2) für das Messignal einer zu ermitelnden Spannung.

## Revendications

1. Procédé pour supprimer une perturbation lors de la mesure de variations d'un signal à l'aide d'une sonde corpusculaire (PE), selon lequel on met en place la sonde corpusculaire (PE) sur un échantillon (PR) et on détermine le décalage, qui dépend du potentiel de l'échantillon (PR), de la distribution d'énergie des électrons secondaires (SE) à l'aide d'un dispositif (ST, DT) formant spectromètre et détecteur, et selon lequel on maintient constant le signal fourni par les électrons secondaires et mesuré dans le dispositif (ST, DT) formant spectromètre et détecteur par l'intermédiaire d'un circuit de réaction (RS), et selon lequel on mesure au moins à un instant une tension connue de référence sur l'échantillon (PR), caractérisé par le fait qu'on utilise le signal fourni par les électrons secondaires et résultant de la mesure de la tension de référence pour régler le circuit de réaction (RS) sur un point de fonctionnement prédéterminé, afin de compenser les décalages du point de fonctionnement provoqués par des perturbations pendant la mesure des variations du signal.

2. Procédé suivant la revendication 1, caractérisé par le fait que dans le cas d'écart d'un signal de mesure fourni par les électrons secondaires et qui résulte d'une mesure d'une tension de référence, par rapport à une valeur de consigne correspondante, la tension d'un photomultiplicateur (PH) est modifiée.

3. Procédé suivant l'une des revendications 1 ou 2, caractérisé par le fait que dans le cas d'écart du signal fourni par les électrons secondaires, qui résulte d'une mesure d'une tension de référence, par rapport à une valeur de consigne correspondante le facteur d'amplification d'un amplificateur (V2) branché en aval est modifié.

4. Procédé suivant l'une des revendications 1 à 3, caractérisé par le fait que dans le cas d'écart du signal fourni par les électrons secondaires, qui résulte d'une mesure d'une tension de référence, par rapport à la valeur de consigne correspondante, la durée des impulsions des corpuscules primaires (PE) est modifiée de telle sorte que cet écart est supprimé.

5. Procédé suivant la revendication 1, caractérisé par le fait qu'on utilise le signal, fourni par les électrons secondaires et qui résulte d'une mesure d'une tension de référence, pour régler la valeur de consigne de ce signal.

6. Procédé suivant l'une des revendications 1 à 5, caractérisé par le fait que pour supprimer le fond dans un signal, on soustrait du signal de mesure d'une tension devant être déterminée le signal de mesure d'une tension de référence.

7. Dispositif pour la mise en œuvre du procédé suivant l'une des revendications 1 à 6, comportant un générateur de faisceau corpusculaire, un dispositif (AS, PU) servant à éteindre et allumer le faisceau corpusculaire (PE), un dispositif (ST, DT) formant spectromètre et détecteur et servant à détecter les électrons secondaires (SE) émis au niveau d'un échantillon (PR) et un montage (RS) à l'aide duquel on maintient constant le signal fourni par les électrons secondaires et mesuré dans le disspositif (ST, DT) formant spectromètre et détecteur, caractérisé par un commutateur électronique (ES) servant à commuter le signal fourni par les électrons secondaires entre un circuit d'échantillonage et de maintien (SH1) pour le signal de mesure d'une tension de référence et un circuit d'échantillonnage et de maintien (SH2) pour le signal de mesure d'une tension devant être déterminée.

## Claims

1. A method of suppressing a disturbance in the measurement of signal curves with a corpuscular probe (PE), where the corpuscular probe (PE) is positioned on a specimen (PR) and the shift in the energy distribution of the secondary electrons (SE), which is dependent upon the potential of the specimen (PR), is determined by a spectrometer detector arrangement (ST, DT), where the secondary electron signal, measured in the spectrometer detector arrangement (ST, DT), is maintained constant via a feedback circuit (RS) and where, at at least one time, a known reference voltage is measured on the specimen (PR), characterised in that the secondary electron signal which results from the measurement of the reference voltage is used to adjust the feedback circuit (RS) to a predetermined operating point in order to compensate the shifts of the operating point which are caused by disturbances during the measurement of the signal curves.

2. A method as claimed in claim 1, characterised in that in the event of deviations in a secondary electron measurement signal, which results from a measurement of a reference voltage, from a appropriate theoretical value, the voltage of a photo-multiplier (PH) is modified.

3. A method as claimed in one of the claims 1 or 2, characterised in that in the event of deviations in the secondary electron signal, which results from a measurement of a reference voltage, from an appropriate theoretical value, the amplification factor of a subsequently connected amplifier (V2) is modified.

4. A method as claimed in one of the claims 1 to 3, characterised in that in the event of deviations in the secondary electron signal, which results from a measurement of a reference voltage, from an appropriate theoretical value, the pulse width of the primary corpuscles (PE) is modified in such manner that this deviation is eliminated.

5. A method as claimed in claim 1, characterised in that the secondary electron signal, which results from a measurement of a reference voltage, is used to regulate the theoretical value of this secondary electron signal.

6. A method as claimed in one of the claims 1 to 5, characterised in that the measurement signal of a reference voltage is substracted from the measurement signal of a voltage which is to be determined, in order to suppress a signal background.

7. A device for the implementation of a method as claimed in one of the claims 1 to 6, with a corpuscular beam generator, with an arrangement (AS, PU) which serves to pulse off and on the corpuscular beam (PE), with a spectrometer detector arrangement (ST, DT) which serves to detect the secondary electrons (SE) triggered on a specimen (PR), and with a circuit arrangement (RS) with which the secondary electron signal, measured in the spectrometer detector arrangement (ST, DT), is maintained constant, characterised by an electronic switch (ES) which serves to switch over the secondary electron signal between a sample-and-hold circuit (SH1) for the measurement signal of a reference voltage and a sample-and-hold circuit (SH2) for the measurement signal of a voltage which is to be detected.

# FIG 1

# FIG 2